# EUROPÄISCHE PATENTSCHRIFT

(11) **EP 0 795 623 B1**
(45) Veröffentlichungstag und Bekanntmachung des Hinweises auf die Patenterteilung: **17.04.2002**
(21) Anmeldenummer: 96119943.7
(22) Anmeldetag: 12.12.1996
(51) Int. Cl.: C23C 14/35, C23C 14/54

(54) **Vorrichtung zum Aufbringen dünner Schichten auf ein Substrat**
Apparatus for depositing thin layers on a substrate
Dispositif pour la déposition des couches minces sur un substrat

(30) Priorität: 14.03.1996 DE 19609970
(43) Veröffentlichungstag der Anmeldung: 17.09.1997
(73) Patentinhaber: Unaxis Deutschland Holding GmbH, 63450 Hanau (DE)
(72) Erfinder: Szczyrbowski, Joachim, Dr., 63773 Goldbach (DE); Teschner, Götz, 63450 Hanau (DE); Bruch, Jürgen, 63546 Hammersbach (DE)
(74) Vertreter: Bockhorni, Josef, Dipl.-Ing.

(56) Entgegenhaltungen:
- DE-A- 2 700 979
- DE-A- 4 138 927
- US-A- 4 428 811

## Beschreibung

Die Erfindung betrifft eine Vorrichtung zum Aufbringen dünner Schichten auf ein Substrat, umfassend eine Stromversorgung, die mit einer in einer Vakuumkammer angeordneten Kathode verbunden ist und mit einem Target zusammenwirkt, dessen abgestäubte Teilchen sich auf dem Substrat niederschlagen, das dem Target gegenüberliegend angeordnet ist, eine Prozeßgasquelle, die mit der Vakuumkammer verbunden ist und die Evakuierung der Vakuumkammer ermöglicht.

Um einen stabilen Sputterprozeß am gewünschten Arbeitspunkt zu gewährleisten, ist eine sehr genaue Regelung der Kathodenstromversorgung bei konstantem Gaseinlaß erforderlich. Die einfachsten Regelmodi sind hierfür die Strom-, die Spannungs- und die Leistungsregelung. Diese Regelungen allein reichen jedoch nicht aus, um eine Sputterkathode über einen längeren Zeitraum im kritischen Bereich der Stromspannungscharakteristik zu fahren (z. B. im Übergangsbereich zwischen metallischem und oxidischem Mode).

Man hat deshalb bereits vorgeschlagen, die Regelung des Gaseinlasses bei konstanter Leistungseinspeisung mit Hilfe eines Plasma-Emission-Monitors durchzuführen (DD 271 827 A). Bei dieser bekannten Einrichtung zum stabilen Betrieb, bestehend aus einem Plasma-Emissions-Monitor mit Meßsystem zur Umwandlung eines optischen Signals in ein elektrisches Signal und einer gemeinsamen Stromversorgung mit einer Umschalteinrichtung zum Pulsbetrieb des Plasmatrons ist jedem Plasmatron ein Meßsystem zugeordnet, deren Ausgänge über Haltestufen an eine Überlagerungseinrichtung angeschlossen sind, wobei die Umschalteinrichtung über Steuerstufen mit Überlagerungseinrichtung verbunden ist und wobei an der Überlagerungseinrichtung ausgangszeitig der Plasma-Emissions-Monitor und das Ventil für den Reaktionsgaseinlaß angeschlossen sind.

Bekannt ist auch ein Verfahren zur Kontrolle der Aufdampfrate (DE 27 00 979 A) und/oder der Zusammensetzung des aufzudampfenden Materials während eines Aufdampfprozesses im Vakuum, bei dem ein Anteil des aufzudampfenden Materials eine Meßzone durchströmt, in der das aufzudampfende Material einer Strahlung ausgesetzt wird, wobei die Art der Strahlung so gewählt wird, daß die Elektronen von zumindest einem Teil der die Meßzone durchströmenden Atome des aufzudampfenden Materials auf ein höheres Energieniveau gehoben werden, und daß die beim Rück-Übergang in den niedrigen Energiezustand entstehenden Photonen als Maß für die Aufdampfrate bzw. als Informationssignal für die Zusammensetzung des aufzudampfenden Materials registriert werden.

Diese bekannten Regelungen mittels eines Plasma-Emissions-Monitors bzw. nach DE 27 00 979 A haben jedoch den Nachteil, daß sie sehr teuer in der Herstellung sind, daß sie eine hohe Empfindlichkeit gegenüber Fremdlichtreflexen aufweisen, daß sie eine besonders genaue Justage erfordern und daß sie eine hohe Empfindlichkeit gegenüber unkontrollierten Sputtergasdotierungen besitzen.

Diese optischen Meßverfahren haben außerdem für Anlagen, die im Dauerbetrieb beschichten einen entscheidenden Nachteil. Sie benötigen ein Fenster zur Lichtauskopplung. Dieses Fenster wird durch Streudampf beschichtet, wodurch sich die optischen Eigenschaften des Fensters und somit die Meßwerte ändern.

Der vorliegenden Erfindung liegt die Aufgabe zugrunde, eine Vorrichtung des eingangs beschriebenen Typs zu schaffen, die die Nachteile der bekannten Regelvorrichtungen vermeidet und insbesondere preiswert in der Herstellung ist und einen robusten Langzeitbetrieb ermöglicht.

Diese Aufgabe wird erfindungsgemäß gelöst durch einen Meßfühler, der als eine potentiometrische Meßelektrode ausgestaltet ist, die den Anteil eines Gases in der Vakuumkammer oder in einer mit der Vakuumkammer verbundenen Zuleitung mit einem Referenzgas vergleicht und das gewonnene Signal bzw. die zustande kommende Potentialdifferenz an die einen Signalverstärker einschließende Regeleinheit weiterleitet, die ihrerseits den Generator der Stromversorgung ansteuert.

Weitere Einzelheiten und Merkmale sind in den Unteransprüchen näher beschrieben und gekennzeichnet.

Die Erfindung läßt die verschiedensten Ausführungsmöglichkeiten zu; drei davon sind in den anhängenden Zeichnungen (Fig. 1 bis Fig. 3) schematisch näher dargestellt. Die beiliegenden Zeichnungen:
- Fig. 1: das Schema einer Sputteranlage mit Magnetron-Kathode, Vakuumpumpe, Lambda-Sonde, Prozeßgasbehälter und Gasregelventil, wobei die Lambda-Sonde innerhalb der Vakuumkammer im Bereich des Sauganschlusses der Vakuumpumpe angeordnet ist,
- Fig. 2: das Schema einer ähnlichen Anlage (wie in Fig. 1), jedoch mit Hauptund Vorpumpe, wobei die Lambda-Sonde in der Verbindungsleitung der beiden Pumpen vorgesehen ist,
- Fig. 3: das Schema einer Anlage mit einer zusätzlichen Vakuumpumpe, deren Saug- und Druckseite mit der Vakuumkammer verbunden sind, wobei eine Drossel und die Lambda-Sonde in die Druckleitung der Pumpe eingeschaltet sind und
- Fig. 4: den Stromlaufplan der Verstärkereinheit für den Generator

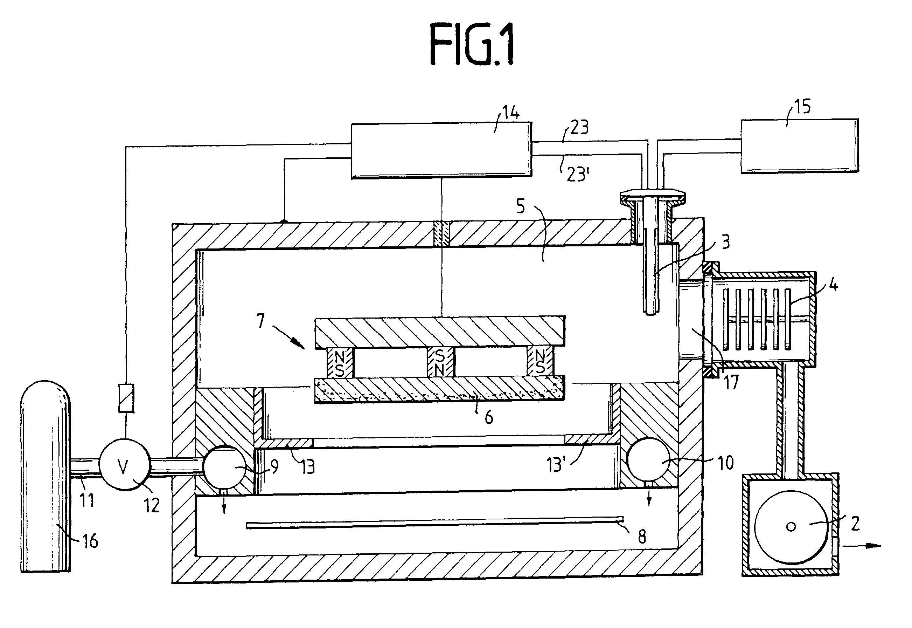

Die Vorrichtung gemäß Fig. 1 besteht im wesentlichen aus der in der Vakuumkammer 5 angeordneten Sputterkathode 7 mit Target 6, dem unterhalb des Targets 6 gehaltenen Substrat 8, den beiden seitlich der Kathode vorgesehenen Gaskanälen 9, 10 mit Gaseinlaßleitung 11, Gasvorratsbehälter 16 und Gasflußregelventil 12, der Blende 13, 13', der Stromversorgung mit Regler 14, der Lambda-Sonde 3 mit Sondenheizung 15 und der Vakuumpumpe 4 mit Vorpumpe 2.

Die Lambda-Sonde 3 ist direkt vor der Turbomolekularpumpe 4 im Bereich des Ansaugstutzens 17 angeordnet. Das Target 6 besteht aus Titan und wird in einem Argon-Sauerstoff-Gemisch gesputtert, wobei eine TiO₂-Schicht auf dem Substrat 8 aufwächst. Für die Prozeßregelung dient die Lamda-Sonde 3 mit Zirkonoxid-Elektrolyt, die einen guten Sauerstoffionenleiter bildet.

Die Sondenspannung ist eine Funktion des kontrollierten Gases "Sauerstoff". Den Referenzdruck bildet der Sauerstoffpartialdruck der umgebenden Atmosphäre. Um eventuelle Schwankungen der Sondenspannung, die durch Schwankungen des Luftdrucks und/oder der Sondentemperatur verursacht werden können, zu eliminieren, müssen beide Größen stabilisiert werden. Der Sputterprozeß wird mit konstantem Sauerstofffluß durchgeführt.

Die Sondenspannung ist eine Funktion des Sauerstoffpartialdrucks in der Sputterkammer 5 und dient der Leistungsregelung der Kathodenstromversorgung.

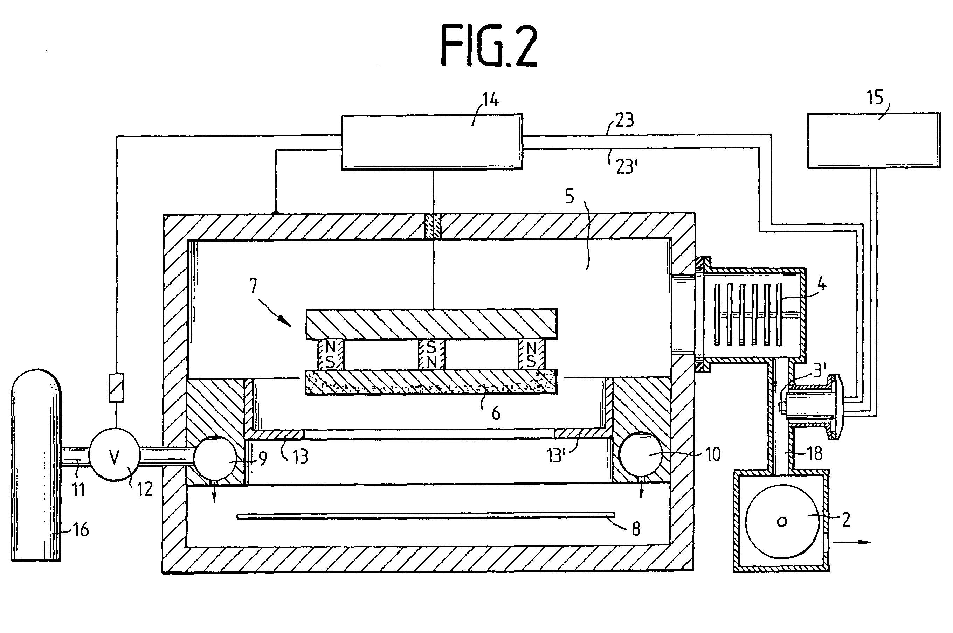

Die Ausführungsform gemäß Fig. 2 unterscheidet sich von derjenigen nach Fig. 1 nur dadurch, daß die Lamda-Sonde 3' in die Verbindungsleitung 18 eingeschaltet ist, also in einem mit dem Druck in der Vakuumkammer 5 korrespondierenden Druckbereich mißt.

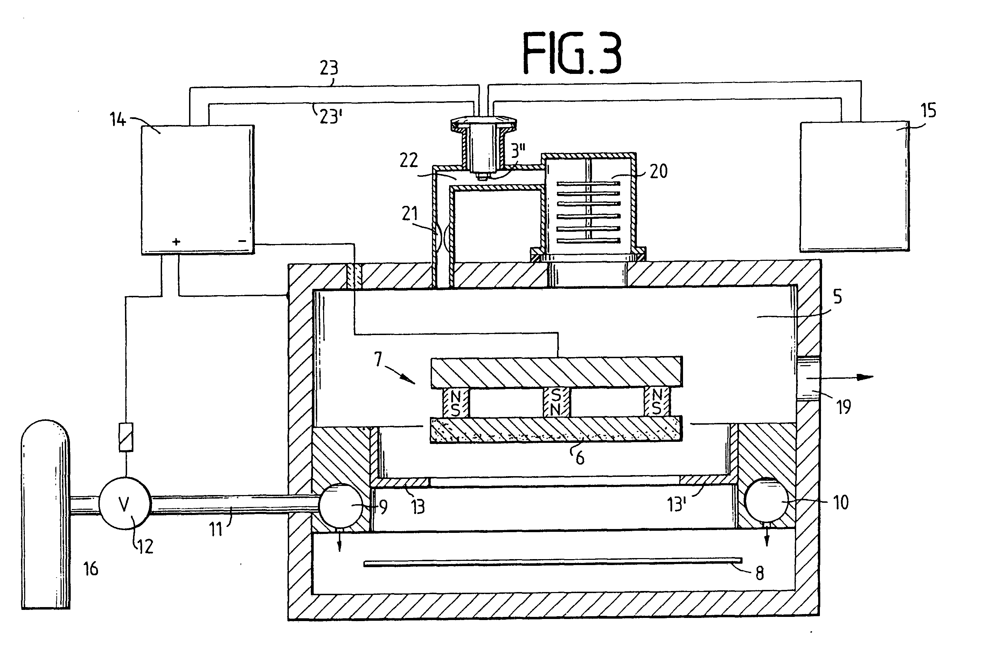

Das Ausführungsbeispiel nach Fig. 3 weist eine Lambda-Sonde 3" auf, die in die Druckleitung 22 einer mit der Vakuumkammer 5 verbundenen Vakuumpumpe 20 angeschlossen ist die in die Vakuumkammer 5 einmündet, wobei in diese Druckleitung eine Drossel 21 eingeschaltet ist. Die Lambda-Sonde 3" ist zwischen den Vakuumpumpen und der Drossel eingeordnet.

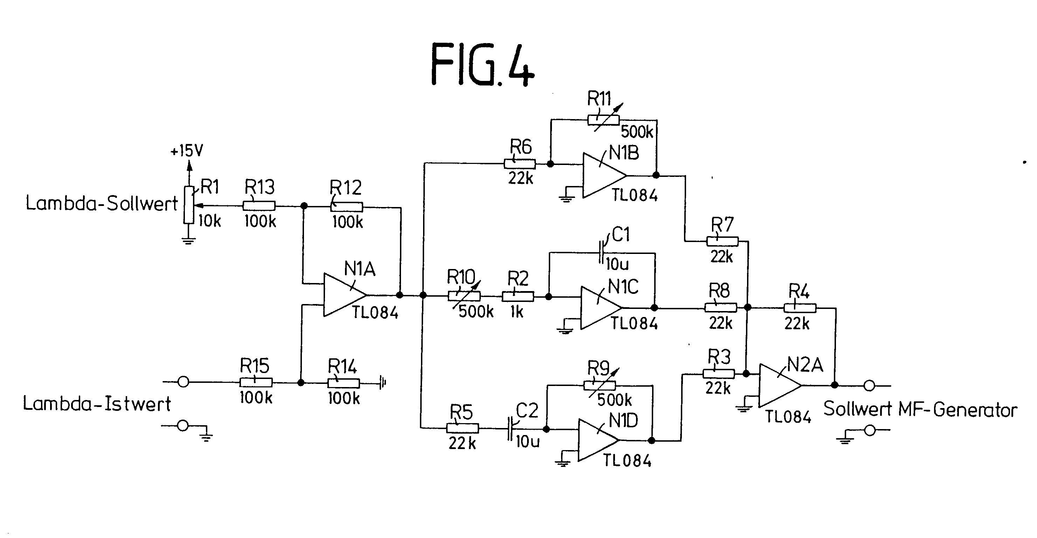

In Fig. 4 ist der zwischen dem Generator zur Stromversorgung der Kathode 7 und der Lambda-Sonde 3, 3', 3" zu einer Einheit 14 zusammengefaßte Verstärker dargestellt, der einerseits das über die Leitung 23, 23' geführte Signal der Lambda-Sonde 3, 3', 3" erhält und andererseits den Steuerstrom für den Generator, beispielsweise einen MF-Generator, liefert.

### Bezugszeichenliste

- 2: Vakuumpumpe, Vorpumpe
- 3, 3', 3": Lambda-Sonde
- 4: Vakuumpumpe
- 5: Vakuumkammer
- 6: Target
- 7: Magnetronkathode
- 8: Substrat
- 9: Gaskanal
- 10: Gaskanal
- 11: Gaseinlaßleitung
- 12: Magnetventil
- 13, 13': Blende
- 14: Regler mit Stromversorgung
- 15: Sondenheizung
- 16: Gasbehälter
- 17: Ansaugstutzen der Vakuumpumpe
- 18: Verbindungsleitung
- 19: Pumpenanschluß
- 20: Vakuumpumpe
- 21: Drossel
- 22: Druckleitung
- 23, 23': Signalleitung

## Patentansprüche

1. Vorrichtung zum Aufbringen dünner Schichten auf ein Substrat (8), umfassend eine Stromversorgung (14), die mit einer in einer Vakuumkammer (5) angeordneten Kathode (7) verbunden ist und mit einem Target (6) zusammenwirkt, dessen abgestäubte Teilchen sich auf dem Substrat (18) niederschlagen, das dem Target (6) gegenüberliegend angeordnet ist, eine Prozeßgasquelle (16), die mit der Vakuumkammer (5) verbunden ist, wobei zwischen Vakuumkammer (5) und Prozeßgasquelle (16) ein von einem Regler gesteuertes Dosierventil (12) eingeschaltet ist und mit mindestens einer Vakuumpumpe (2, 4, 20), deren Saugseite mit der Vakuumkammer (5) verbunden ist, **gekennzeichnet durch** einen Meßfühler (3, 3', 3"), der als eine potentiometrische Meßelektrode ausgestaltet ist, die den Anteil eines Gases in der Vakuumkammer (5) oder in einer mit der Vakuumkammer (5) verbundenen Zuleitung (17) über eine Referenzelektrode mit einem Referenzgas oder einem die Referenzelektrode ersetzenden Festkörper vergleicht und das sogenannte Signal bzw. die zustande kommende Potentialdifferenz an die einen Signalverstärker einschließende Regeleinheit (14) weiterleitet, die ihrerseits den Generator der Stromversorgung ansteuert.

2. Vorrichtung nach Anspruch 1, **dadurch gekennzeichnet, daß** die Meßelektrode eine sogen. Lambda-Sonde 3, 3', 3" und das Prozeßgas Sauerstoff ist.

3. Vorrichtung nach den Ansprüchen 1 und 2, **dadurch gekennzeichnet, daß** die Meßelektrode (3) in dem Bereich der Ansaugöffnung (17) für die Vakuumpumpe (4) angeordnet ist.

4. Vorrichtung nach den Ansprüchen 1 und 2, **dadurch gekennzeichnet, daß** die Meßelektrode (3') in der Verbindungsleitung (18) zwischen Vorpumpe (2) und Hauptpumpe (4) eingeschaltet ist.

5. Vorrichtung nach den Ansprüchen 1 und 2, **dadurch gekennzeichnet, daß** die Meßelektrode (3") in die an die Vakuumkammer (5) angeschlossene Druckleitung (22) einer Vakuumpumpe (20) eingeschaltet ist, wobei im Verbindungsstück der Druckleitung (22) zwischen Meßelektrode (3") und der Vakuumkammer (5) eine Drossel (21) angeordnet ist, und die Vakuumpumpe (20) mit ihrer Saugseite direkt mit der Vakuumkammer (5) verbunden ist.

## Claims

1. Apparatus for applying thin layers to a substrate (8), including a current supply (14), which is connected to a cathode (7) disposed in a vacuum chamber and cooperates with a target (6), the atomised particles of which deposit on the substrate (8), which is arranged opposite to the target (6), a process gas source (16), which is connected to the vacuum chamber (5), wherein connected between the vacuum chamber (5) and process gas source (16) there is a metering valve (12) controlled by a controller, and including at least one vacuum pump (2,4,20), the suction side of which is connected to the vacuum chamber (5), **characterised by** a measuring sensor (3,3',3"), which is constructed in the form of a potentiometric measuring electrode, which compares the content of a gas in the vacuum chamber (5) or in a supply pipe (17) connected to the vacuum chamber (5) by means of a reference electrode with a reference gas or a solid body replacing the reference electrode and passes on the so-called signal or the potential difference which occurs to the control unit (14), which includes a signal amplifier and for its part controls the generator of the current supply.

2. Apparatus as claimed in claim 1, **characterised in that** the measuring electrode is a so-called Lamda probe (3,3',3") and the process gas is oxygen.

3. Apparatus as claimed in claims 1 or 2, **characterised in that** the measuring electrode (3) is arranged in the region of the suction opening (15) for the vacuum pump (4).

4. Apparatus as claimed in claims 1 and 2, **characterised in that** the measuring electrode (3') is connected in the connecting pipe (18) between the forepump (2) and main pump (4).

5. Apparatus as claimed in claims 1 and 2, **characterised in that** the measuring electrode (3") is connected into the pressure pipe (22), connected to the vacuum chamber (5), or the vacuum pump (20), whereby arranged in the connector of the pressure pipe (22) between the measuring electrode (3") and the vacuum chamber (5) there is a throttle (21) and the suction side of the vacuum pump (20) is directly connected to the vacuum chamber (5).

## Revendications

1. Dispositif pour la déposition de couches minces sur un substrat (8), comportant une alimentation électrique (14) qui est connectée à une cathode (7) agencée dans une chambre à vide (5) et qui coopère avec une cible (6), dont les particules pulvérisées se précipitent sur le substrat (18) qui est agencé à l'opposé de la cible (6), une source de gaz de réaction (16) qui est reliée à la chambre à vide (5), une valve de dosage (12) commandée par un régulateur étant interposée entre la chambre à vide (5) et la source de gaz de réaction (16), et comportant au moins une pompe à vide (2, 4, 20) dont le côté aspiration est relié à la chambre à vide (5), **caractérisé par** un capteur de mesure (3, 3', 3") qui est réalisé sous la forme d'une électrode de mesure potentiométrique qui compare la proportion d'un gaz dans la chambre à vide (5) ou dans une conduite d'amenée (17), reliée à la chambre à vide (5), par l'intermédiaire d'une électrode de référence, avec un gaz de référence ou avec un corps solide remplaçant l'électrode de référence, et qui transmet le signal proprement dit ou la différence de potentiel qui se forme à l'unité de régulation (14) comprenant un amplificateur de signal, laquelle pilote à son tour le générateur de l'alimentation électrique.

2. Dispositif selon la revendication 1, **caractérisé en ce que** l'électrode de mesure est une sonde dite lambda 3, 3', 3", et **en ce que** le gaz de réaction est de l'oxygène.

3. Dispositif selon les revendications 1 et 2, **caractérisé en ce que** l'électrode de mesure (3) est agencée dans la zone de l'ouverture d'aspiration (17) pour la pompe à vide (4).

4. Dispositif selon les revendications 1 et 2, **caractérisé en ce que** l'électrode de mesure (3') est interposée dans la conduite de liaison (18) entre la pompe à vide préliminaire (2) et la pompe principale (4).

5. Dispositif selon les revendications 1 et 2, **caractérisé en ce que** l'électrode de mesure (3") est interposée dans la conduite sous pression (22), branchée à la chambre à vide (5), d'une pompe à vide (20), et un étranglement (21) est agencé dans le tronçon de liaison de la conduite sous pression (22) entre l'électrode de mesure (3") et la chambre à vide (5), et la pompe à vide (20) est reliée par son côté aspiration directement à la chambre à vide (5).
